# EUROPÄISCHE PATENTSCHRIFT

(11) **EP 1 549 997 B1**
(45) Veröffentlichungstag und Bekanntmachung des Hinweises auf die Patenterteilung: **14.10.2009**
(21) Anmeldenummer: 03750285.3
(22) Anmeldetag: 21.08.2003
(51) Int. Cl.: G02F 1/13357, G02B 27/01

(54) **EINRICHTUNG ZUR ERZEUGUNG EINES BILDES**
DEVICE FOR GENERATING AN IMAGE
DISPOSITIF DE PRODUCTION D'IMAGES

(30) Priorität: 27.09.2002 DE 10245580
(43) Veröffentlichungstag der Anmeldung: 06.07.2005
(73) Patentinhaber: SIEMENS AKTIENGESELLSCHAFT, 80333 München (DE)
(72) Erfinder: BLUME, Heinrich-Jochen, 64291 Darmstadt (DE); BROHM, Thomas, 64859 Eppertshausen (DE); HOHMANN, Kai, 36179 Bebra (DE); MAYER, Ralf, 67295 Bolanden (DE); NOLL, Heinrich, 64823 Gross-Umstadt (DE)
(86) Internationale Anmeldenummer: PCT/DE2003/002783
(87) Internationale Veröffentlichungsnummer: WO 2004/031843

(56) Entgegenhaltungen:
- EP-A- 0 838 715
- EP-A- 1 164 566
- US-A1- 2001 035 922
- PATENT ABSTRACTS OF JAPAN vol. 1999, no. 13, 30. November 1999 (1999-11-30) & JP 11 231316 A (RICOH CO LTD), 27. August 1999 (1999-08-27)

## Beschreibung

Die Erfindung betrifft eine Einrichtung zur Erzeugung eines Bildes mit einer Lichtventile enthaltenden Bildwiedergabevorrichtung.

Um Fahrzeugführern Informationen zu übermitteln, ohne dass diese ihren Blick von der zu befahrenden Straße oder dem zu befliegenden Luftraum abwenden müssen, sind sogenannte Head-up-Displays bekannt geworden, mit denen ein die Informationen darstellendes Bild in die Frontscheibe eines Fahrzeugs eingeblendet wird. Damit es auch noch bei hellem Umgebungslicht sichtbar ist, ist dazu eine hohe Leuchtdichte des Bildes erforderlich.

Das Dokument JP 11231316 beschreibt ein Liquid Crystal Display. Zur Beleuchtung ist eine LED-Matrix vorgesehen. Hierbei werden jeweils vier LEDs mit drei Farben als eine Lichtquelle verwendet. Ein Linsengitter befindet sich über der LED-Matrix, wobei jeweils eine Linseneinheit zu einer Lichtquelle korrespondiert.

EP1164566 beschreibt ein Display mit einem gitterförmigen Reflektor.

Aufgabe der Erfindung ist es daher, ein Bild hoher Leuchtdichte mit Einrichtungen zu erzeugen, welche für den Betrieb in einem Fahrzeug geeignet sind, also insbesondere eine geringe Baugröße und geringes Gewicht aufweisen und möglichst wenig Verlustleistung aufnehmen bzw. als Wärme abgeben.

Diese Aufgabe wird erfindungsgemäß dadurch gelöst, dass zur Hinterleuchtung der Bildwiedergabevorrichtung eine Lichtquelle, bestehend aus einer Leuchtdioden-Matrix, vorgesehen ist und dass zwischen der Lichtquelle und der Bildwiedergabevorrichtung eine optische Einrichtung zur Bündelung und Streuung des von den Leuchtdioden erzeugten Lichts angeordnet ist.

Zu einer gleichmäßigen Lichtverteilung trägt bei, dass die Einrichtung zur Bündelung und Streuung einen gitterförmigen Reflektor umfasst, der jeweils für einen Matrixpunkt einen Lichtkanal bildet, dessen Wände reflektierend sind.

Bei der Anwendung der erfindungsgemäßen Einrichtung als Head-up-Display kann nicht ausgeschlossen werden, dass Licht entgegen dem von der erfindungsgemäßen Einrichtung abgestrahlten Licht auf die Bildwiedergabevorrichtung fällt und dort reflektiert wird. Damit dieses reflektierte Licht nicht zusammen mit dem das Bild darstellenden Licht in Richtung auf den Betrachter reflektiert wird, ist vorgesehen, dass die Bildwiedergabevorrichtung auf einer Seite der Einrichtung einen größeren Abstand zur Lichtquelle als auf der anderen Seite aufweist. Durch diese Schrägstellung der Bildwiedergabevorrichtung wird die störende Reflexion vermieden und gleichzeitig ein geradliniger Weg des Lichts der Lichtquelle in Richtung auf den Betrachter gewährleistet.

Die Erfindung ermöglicht eine kompakte Einrichtung für die Erzeugung hoch auflösender Bilder mit hoher Leuchtdichte und gleichmäßiger Leuchtdichteverteilung über die gesamte Bildfläche. Dabei sorgt die Einrichtung zur Bündelung und Streuung dafür, dass das von den Leuchtdioden erzeugte Licht auf die Fläche der Bildwiedergabevorrichtung konzentriert wird, ohne dass eine störende Abbildung der einzelnen Leuchtdioden erfolgt. Ein bevorzugtes Anwendungsgebiet der erfindungsgemäßen Einrichtung sind graphische Head-up-Displays für Fahrzeuganwendungen.

Bei der erfindungsgemäßen Einrichtung hat es sich als günstig herausgestellt, wenn jeweils ein Matrixpunkt von mehreren Leuchtdioden gebildet wird.

Obwohl die erfindungsgemäße Einrichtung grundsätzlich auch für monochrome Displays geeignet ist, liegt ein bevorzugtes Anwendungsgebiet bei der farbigen Darstellung, wobei insbesondere vorgesehen ist, dass die Leuchtdioden jeweils eines Matrixpunktes verschieden farbiges Licht aussenden, wobei insbesondere vier Leuchtdioden einen Matrixpunkt bilden.

Ein besonders heller Bildeindruck im Sinne der Empfindlichkeitskurve des menschlichen Auges kann dadurch erreicht werden, dass zwei grün leuchtende Leuchtdioden, eine blau leuchtende und eine rot leuchtende Leuchtdiode je Matrixpunkt vorgesehen sind. Dabei kann der Farbraum einschließlich der Farbe weiß weitgehend dargestellt werden.

Sofern dies nicht erforderlich ist oder eine Einschränkung der darzustellenden Farben zugunsten einer helleren Darstellung ausgewählter Farben gewünscht wird, können die Leuchtdioden auch anders ausgewählt werden. Zur Darstellung von Signalfarben, wie beispielsweise rot, orange und grün, können zwei grün leuchtende und zwei rot leuchtende Leuchtdioden je Matrixpunkt vorgesehen sein.

Eine vorteilhafte Ausgestaltung der erfindungsgemäßen Einrichtung ermöglicht eine weitere Steigerung der Leuchtdichte dadurch, dass die Matrixpunkte von jeweils einem Reflektor umgeben sind.

Eine Weiterbildung der erfindungsgemäßen Einrichtung ermöglicht eine Darstellung von farbigen Bildern dadurch, dass den Lichtventilen Farbfilter verschiedener spektraler Durchlassbereiche zugeordnet sind, wobei die Durchlassbereiche der Farbfilter an die spektrale Lichtverteilung der Leuchtdioden angepasst sind.

Diese Ausgestaltung kann derart ausgebildet sein, dass mindestens ein Grünfilter einen Durchlassbereich aufweist, der ferner Teile der Spektralbereiche von rot und grün leuchtenden Leuchtdioden erfasst. Hierdurch wird eine weitere Steigerung der Leuchtdichte erzielt - allerdings zu Lasten der maximal darstellbaren Farbsättigung, was bei einem Großteil der Anwendungen nicht stört.

Es ist vorzugsweise vorgesehen, dass sich der Querschnitt jeweils eines Lichtkanals in Richtung auf die Bildwiedergabevorrichtung erweitert. Diese Weiterbildung kann derart ausgestaltet sein, dass zwischen dem Reflektor ein rahmenförmiger weiterer Reflektor vorgesehen ist.

Zur weiteren Verbesserung der gleichmäßigen Leuchtdichteverteilung kann bei der erfindungsgemäßen Einrichtung vorgesehen sein, dass die Einrichtung zur Bündelung und Streuung ferner eine zwischen dem gitterförmigen Reflektor und der Bildwiedergabevorrichtung angeordnete Streuscheibe umfasst, wobei zwischen dem gitterförmigen Reflektor und der Streuscheibe ein Abstand vorgesehen ist.

Streuscheiben mit integrierten streuenden Partikeln bewirken eine unerwünschte Dämpfung des Lichtstroms, die dadurch vermindert werden kann, dass die Streuscheibe ein oberflächenstrukturierter Diffusor ist. Vorzugsweise ist dabei vorgesehen, dass die Oberfläche derart strukturiert ist, dass der Streuwinkel in einer Richtung größer als in der anderen Richtung ist, so dass eine elliptische Streuung entsteht. Bei einem länglichen Display kann die größere Achse des Streuwinkels in Richtung der größeren Ausdehnung des Displays angeordnet sein.

Eine kostengünstige Herstellung der erfindungsgemäßen Einrichtung wird durch Verwendung geeigneter Kunststoffe ermöglicht. So kann beispielsweise vorgesehen sein, dass der gitterförmige Reflektor aus Kunststoff gespritzt ist.

Eine andere vorteilhafte Ausgestaltung trägt zu einer besseren Ausnutzung des von den Leuchtdioden erzeugten Lichts dadurch bei, dass zwischen der Einrichtung zur Bündelung und Streuung und der Lichtquelle ein Polarisationsfilter angeordnet ist, das Licht einer vorgegebenen Polarisationsrichtung durchlässt und Licht anderer Polarisationsrichtungen reflektiert.

Eine kompakte und optisch wirksame erfindungsgemäße Einrichtung wird dadurch erzielt, dass die Wiedergabevorrichtung, die Lichtquelle und die Einrichtung zur Bündelung und Streuung im Wesentlichen die gleiche Fläche einnehmen.

Eine andere Ausführungsform der Erfindung besteht darin, dass die Bildwiedergabevorrichtung ein Niedrigtemperatur-Polysilizium-TFT-Display ist. Dadurch wird eine größere Apertur und damit eine größere Transmission und Display-Helligkeit gegenüber einem Standard-TFT-Display erzielt.

Im folgenden werden noch einige Vorteile der erfindungsgemäßen Einrichtung aufgeführt. So wird durch die Abstimmung zwischen RGB-Lichtquelle und Farbdisplay die Darstellung von graphischen Farbbildern in einem Head-up-Display bei ausreichender Leuchtdichte ermöglicht. Im Zusammenspiel mit dem Reflektor und der Linse wird eine gleichmäßige Farb- und Leuchtdichte-Verteilung der Hinterleuchtung auf der Fläche des Flüssigkristall-Displays erreicht. Das Kontrast-Maximum des Flüssigkristall-Displays wird durch die leichte Schrägstellung des Displays gegenüber der Lichtquelle in die Betrachtungsrichtung gedreht.

Im Flüssigkristall-Farbdisplay können konfigurierbare Bildinhalte farbig dargestellt werden. Der Bildinhalt kann somit an die Fahrsituation angepasst werden. Der Bauraum für die gesamte Bilderzeugungseinrichtung beträgt beim praktisch ausgeführten Beispiel nur wenige Kubikzentimeter. Durch die Wahl der Farben der Leuchtdioden und des dazugehörigen Displays kann der jeweils darzustellende Farbraum beeinflusst werden. Beispielsweise kann anstelle eines RGB-Leuchtdioden-Rasters ein Rot-Grün-Leuchtdioden-Raster gewählt werden und in entsprechender Weise im Flüssigkristall-Display die blauen Filterelemente durch grüne ersetzt werden. Dann ergibt sich ein eingeschränkter Farbraum mit nochmals deutlich erhöhter Leuchtdichte.

Die Erfindung lässt zahlreiche Ausführungsformen zu. Mehrere davon sind schematisch in der Zeichnung anhand mehrerer Figuren dargestellt und nachfolgend beschrieben. Es zeigt:
- Fig. 1: einen Schnitt durch ein Ausführungsbeispiel,
- Fig. 2: eine Draufsicht auf den gitterförmigen Reflektor bei dem Ausführungsbeispiel nach Fig. 1,
- Fig. 3: eine vergrößerte Darstellung eines Ausschnitts aus Fig. 1 zur Erläuterung verschiedener Details,
- Fig. 4: eine vergrößerte Darstellung eines Ausschnitts eines anderen Ausführungsbeispiels und

- Fig. 5: ein Teil des Linsenrasters.

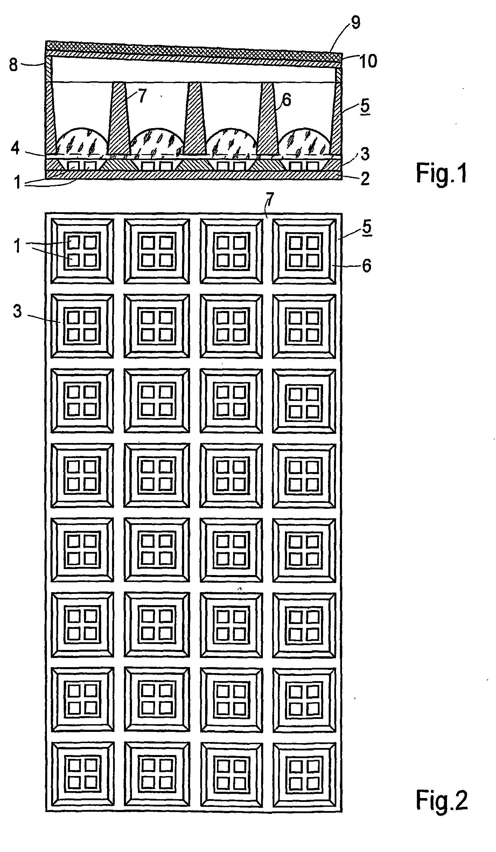

Bei dem Ausführungsbeispiel nach den Figuren 1 und 2 ist als Lichtquelle ein Raster von 4 x 8 Gruppen von jeweils vier Leuchtdioden 1 vorgesehen, die auf einem Träger 2 montiert sind. Zwischen den Gruppen befinden sich Stege 3, deren schräg stehende Oberfläche als Reflektor dient.

Über der Lichtquelle 1, 2, 3 liegt ein Linsenraster 4, an das sich ein gitterförmiger Reflektor 5 anschließt.

Die Stege 3, das Linsenraster 4 sowie die schräg verlaufenden Oberflächen 6 des gitterförmigen Reflektors 5 bewirken eine gleichförmige Lichtverteilung. Um Abschattungen durch die Stege 7 des Reflektors 5 zu vermeiden, ist ein Rahmen 8 vorgesehen, der einen Abstand zwischen dem Reflektor 5 und dem Flüssigkristall-Display 9 bewirkt. Unterhalb des Flüssigkristall-Displays 9 befindet sich eine Streuscheibe 10, um die Gleichförmigkeit der Hinterleuchtung des Flüssigkristall-Displays 9 weiter zu verbessern.

Der Rahmen 8 bewirkt eine Schrägstellung des Flüssigkristall-Displays, so dass von oben einfallendes Licht nicht in der gleichen Richtung reflektiert wird, in der auch das Licht das Flüssigkristall-Display verlässt, um zum Betrachter zu gelangen.

Fig. 2 zeigt die Einrichtung nach Fig. 1 bei abgenommenen Flüssigkristall-Display 9 und bei abgenommener Streuscheibe 10. Die Leuchtdioden 1 sind bei der Darstellung nach Fig. 2 an sich durch das Linsenraster 4 sichtbar. Der Einfachheit halber wurde jedoch eine entsprechende Verzerrung der Leuchtdioden 1 nicht dargestellt.

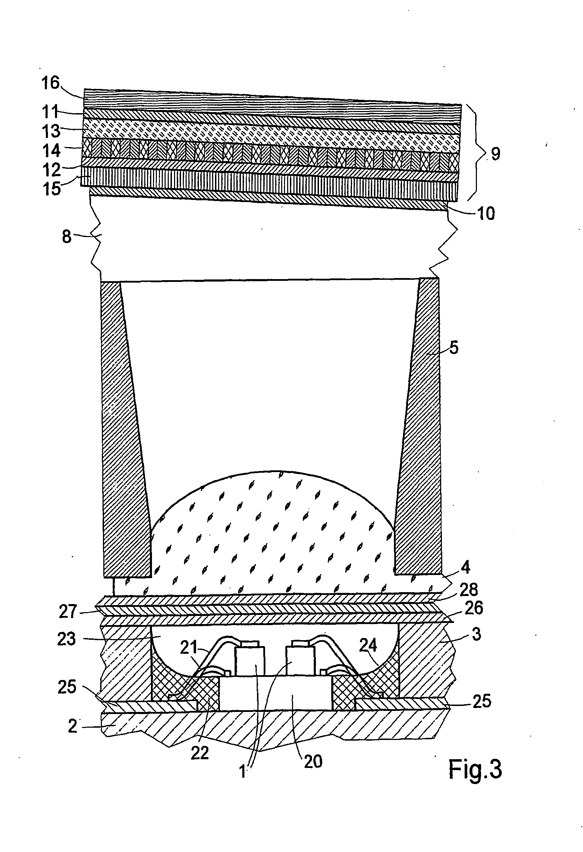

Fig. 3 stellt im Wesentlichen eine Ausschnittsvergrößerung aus Fig. 1 dar und dient zur Erläuterung von Einzelheiten des Flüssigkristall-Displays und der Lichtquelle. Das Flüssigkristall-Display 9 weist zwischen zwei Glasplatten 11, 12 einen Flüssigkristall 13 sowie ein Farbfilter 14 auf. Letzteres besteht aus einem Raster von drei verschiedenfarbigen Farbpunkten, was in Fig. 3 durch unterschiedliche Schraffur gekennzeichnet ist. Korrelierend mit dem Raster des Farbfilters sind nicht dargestellte Steuerelektroden vorgesehen, welche jeweils mit dem Flüssigkristall ein Lichtventil bilden. Außerhalb der Glasplatten 11, 12 befinden sich Polarisatoren 15, 16 mit zueinander senkrecht stehenden Polarisationsebenen.

Die im Zusammenhang mit Fig. 1 kurz beschriebene Lichtquelle ist in Fig. 3 ebenfalls detaillierter dargestellt.

Vier Leuchtdioden 1 sind erhöht in der Mitte eines von Stegen 3 gebildeten Loches auf einem Submount 20 angeordnet. Die Leuchtdioden sind über Bonddrähte 21 mit Leitungen 25 verbunden, die lediglich schematisch durch Schraffur der von ihnen eingenommenen Fläche dargestellt sind. In einer bevorzugten Ausführungsform ist eine der Leuchtdioden rot leuchtend, zwei sind grün leuchtend und die vierte leuchtet blau. Bei dieser Anordnung mischt sich das Licht zu weiß. Der Raum zwischen dem Submount 20 und den Stegen 3 ist mit einer weißen Vergussmasse 22 aufgefüllt, deren Oberfläche 24 als Reflektor für das seitlich von den Leuchtdioden 1 ausgestrahlte Licht dient. Eine transparente Vergussmasse 23 verhindert die Bildung eines Hohlraumes.

Die Verbindung zwischen der Lichtquelle 1, 2, 3 und dem Linsenraster 4 erfolgt bei dem in Fig. 3 dargestellten Ausführungsbeispiel über eine Schicht 26 aus Silikongel, eine PCF-Schicht 27 und einen geeigneten Kleber 28.

Die PCF-Schicht 27 bewirkt, dass von dem mit Hilfe der Leuchtdioden erzeugte Licht nur dasjenige hindurch gelassen wird, das in Richtung des unteren Polarisators 15 polarisiert ist, so dass durch die Polarisation in der PCF-Schicht 27 kein Licht verloren geht. Das anders polarisierte Licht wird von der PCF-Schicht 27 reflektiert und anschließend von der Oberfläche 24 remittiert. Davon gelangt wiederum der Anteil mit der entsprechenden Polarisation zusätzlich durch die PCF-Schicht 27, so dass die PCF-Schicht insgesamt zu einer Erhöhung der Helligkeit beiträgt.

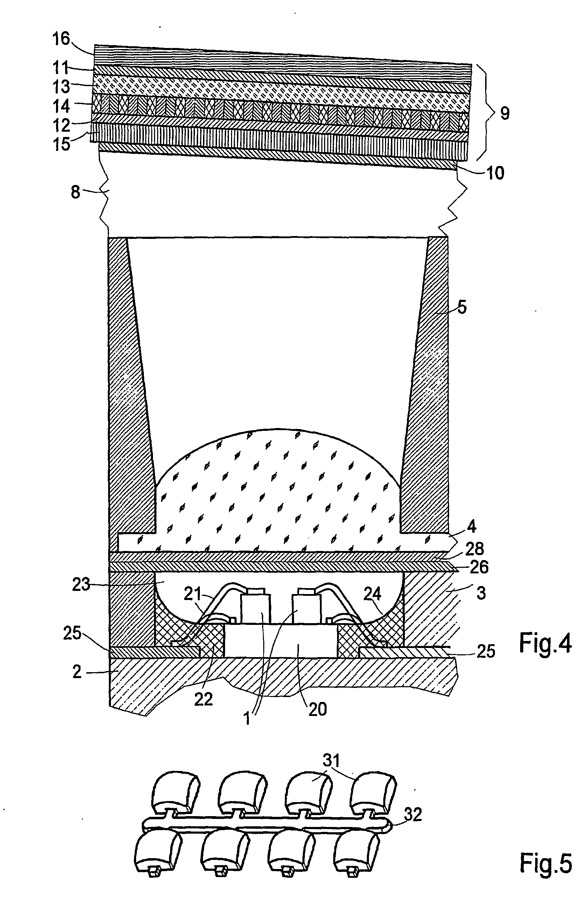

Fig. 4 zeigt ein Ausführungsbeispiel ohne eine PCF-Schicht. Außerdem befindet sich in Fig. 4 der dargestellte Ausschnitt am Rand der Einrichtung.

Fig. 5 zeigt ein Linsenraster 31 mit acht Linsen, die durch Stege 32 zusammengehalten werden. Vier der in Fig. 5 dargestellten Linsenraster sind bei dem Ausführungsbeispiel nach den Figuren 3 und 4 nebeneinander angeordnet.

## Patentansprüche

1. Einrichtung zur Erzeugung eines Bildes, umfassend eine Lichtventile enthaltende Bildwiedergabevorrichtung (9), und eine Lichtquelle zur Hinterleuchtung der Bildwiedergabevorrichtung (9), bestehend aus einer Leuchtdioden-Matrix (1, 2, 3), wobei zwischen der Lichtquelle und der Bildwiedergabevorrichtung eine optische Einrichtung zur Bündelung und Streuung des von den Leuchtdioden erzeugten Lichts angeordnet ist,
wobei die Einrichtung zur Bündelung und Streuung einen gitterförmigen Reflektor (5) umfasst, der jeweils für einen Matrixpunkt einen Lichtkanal bildet, dessen Wände (6) reflektierend sind,
**dadurch gekennzeichnet, dass** die Bildwiedergabevorrichtung (9) auf einer Seite der Einrichtung einen größeren Abstand zur Lichtquelle (1, 2, 3) als auf der anderen Seite aufweist,
wodurch eine Schrägstellung der Bildwiedergabevorrichtung erreicht wird.

2. Einrichtung nach Anspruch 1, **dadurch gekennzeichnet, dass** jeweils ein Matrixpunkt von mehreren Leuchtdioden (1) gebildet wird.

3. Einrichtung nach Anspruch 2, **dadurch gekennzeichnet, dass** die Leuchtdioden (1) jeweils eines Matrixpunktes verschiedenfarbiges Licht aussenden.

4. Einrichtung nach einem der Ansprüche 2 oder 3, **dadurch gekennzeichnet, dass** vier Leuchtdioden (1) einen Matrixpunkt bilden.

5. Einrichtung nach Anspruch 4, **dadurch gekennzeichnet, dass** zwei grün leuchtende Leuchtdioden (1), eine blau leuchtende und eine rot leuchtende Leuchtdiode (1) je Matrixpunkt vorgesehen sind.

6. Einrichtung nach Anspruch 4, **dadurch gekennzeichnet, dass** zwei grün leuchtende und zwei rot leuchtende Leuchtdioden je Matrixpunkt vorgesehen sind.

7. Einrichtung nach einem der vorhergehenden Ansprüche,
**dadurch gekennzeichnet, dass** die Matrixpunkte von jeweils einem Reflektor (3, 24) umgeben sind.

8. Einrichtung nach einem der vorhergehenden Ansprüche,
**dadurch gekennzeichnet, dass** den Lichtventilen Farbfilter (14) verschiedener spektraler Durchlassbereiche zugeordnet sind, wobei die Durchlassbereiche der Farbfilter (14) an die spektrale Lichtverteilung der Leuchtdioden (1) angepasst sind.

9. Einrichtung nach Anspruch 8, **dadurch gekennzeichnet, dass** mindestens ein Grünfilter einen Durchlassbereich aufweist, der ferner Teile der Spektralbereiche von rot und grün leuchtenden Leuchtdioden (1) erfasst.

10. Einrichtung nach einem der vorhergehenden Ansprüche,
**dadurch gekennzeichnet, dass** sich der Querschnitt jeweils eines Lichtkanals in Richtung auf die Bildwiedergabevorrichtung (9) erweitert.

11. Einrichtung nach einem der vorhergehenden Ansprüche,
**dadurch gekennzeichnet, dass** zwischen dem Reflektor (5) ein rahmenförmiger weiterer Reflektor (8) vorgesehen ist.

12. Einrichtung nach einem der vorhergehenden Ansprüche,
**dadurch gekennzeichnet, dass** die Einrichtung zur Bündelung und Streuung ferner eine zwischen dem gitterförmigen Reflektor (5) und der Bildwiedergabevorrichtung (9) angeordnete Streuscheibe (10) umfasst, wobei zwischen dem gitterförmigen Reflektor (5) und der Streuscheibe (10) ein Abstand vorgesehen ist.

13. Einrichtung nach Anspruch 12, **dadurch gekennzeichnet, dass** die Streuscheibe (10) ein oberflächenstrukturierter Diffusor ist.

14. Einrichtung nach Anspruch 13, **dadurch gekennzeichnet, dass** die Oberfläche derart strukturiert ist, dass der Streuwinkel in einer Richtung größer als in der anderen Richtung ist, so dass eine elliptische Streuung entsteht.

15. Einrichtung nach einem der vorhergehenden Ansprüche,
**dadurch gekennzeichnet, dass** der gitterförmige Reflektor (5) aus Kunststoff gespritzt ist.

16. Einrichtung nach einem der vorhergehenden Ansprüche,
**dadurch gekennzeichnet, dass** zwischen der Einrichtung zur Bündelung und Streuung (4, 5, 10) und der Lichtquelle (1, 2, 3) ein Polarisationsfilter (27) angeordnet ist, das Licht einer vorgegebenen Polarisationsrichtung durchlässt und Licht anderer Polarisationsrichtungen reflektiert.

17. Einrichtung nach einem der vorhergehenden Ansprüche,
**dadurch gekennzeichnet, dass** die Wiedergabevorrichtung, die Lichtquelle (1, 2, 3) und die Einrichtung zur Bündelung und Streuung (4, 5, 10) im Wesentlichen die gleiche Fläche einnehmen.

18. Einrichtung nach einem der vorhergehenden Ansprüche,
**dadurch gekennzeichnet, dass** die Bildwiedergabevorrichtung (9) ein Niedrigtemperatur-Polysilizium-TFT-Display ist.

## Claims

1. Device for generating an image, comprising an image reproduction apparatus (9) containing light valves, and a light source for backlighting the image reproduction apparatus (9), consisting of a light emitting diode matrix (1, 2, 3), an optical device for focusing and diffusing the light generated by the light emitting diodes being arranged between the light source and the image reproduction apparatus,
the device for focusing and diffusing comprising a grid-shaped reflector (5) which in each case forms a light channel for a matrix point, the walls (6) of said light channel being reflective,
**characterised in that** the image reproduction apparatus (9) is further away from the light source (1, 2, 3) on one side of the device than on the other side, as a result of which the image reproduction apparatus is inclined.

2. Device according to claim 1, **characterised in that** a matrix point is in each case formed from a plurality of light emitting diodes (1).

3. Device according to claim 2, **characterised in that** each of the light emitting diodes (1) of a matrix point emits different coloured light.

4. Device according to one of claims 2 or 3, **characterised in that** four light emitting diodes (1) form a matrix point.

5. Device according to claim 4, **characterised in that** two green light emitting diodes (1), one blue light emitting diode and one red light emitting diode (1) are provided for each matrix point.

6. Device according to claim 4, **characterised in that** two green and two red light emitting diodes are provided for each matrix point.

7. Device according to one of the preceding claims, **characterised in that** the matrix points are in each case surrounded by a reflector (3, 24).

8. Device according to one of the preceding claims, **characterised in that** colour filters (14) of different spectral passbands are assigned to the light valves (14), the passbands of the colour filters (14) being adjusted to the spectral light distribution of the light emitting diodes (1).

9. Device according to claim 8, **characterised in that** at least one green filter has a passband which further includes parts of the spectral bands of red and green light emitting diodes (1).

10. Device according to one of the preceding claims, **characterised in that** the cross-section of each light channel extends in the direction of the image reproduction apparatus (9).

11. Device according to one of the preceding claims, **characterised in that** a frame-shaped further reflector (8) is provided between the reflector (5).

12. Device according to one of the preceding claims, **characterised in that** the device for focusing and diffusing further includes a diffusion disk (10) arranged between the grid-shaped reflector (5) and the image reproduction apparatus (9), a clearance being provided between the grid-shaped reflector (5) and the diffusion disk (10).

13. Device according to claim 12, **characterised in that** the diffusion disk (10) is a surface-structured diffuser.

14. Device according to claim 13, **characterised in that** the surface is structured such that the diffusion angle in one direction is larger than in the other direction, thereby giving rise to an elliptical diffusion.

15. Device according to one of the preceding claims, **characterised in that** the grid-shaped reflector (5) is injection-moulded out of plastic.

16. Device according to one of the preceding claims, **characterised in that** a polarisation filter (27) is arranged between the device for focusing and diffusing (4, 5, 10) and the light source (1, 2, 3), which allows light of a predefined polarisation direction to penetrate and reflects light from other polarisation directions.

17. Device according to one of the preceding claims, **characterised in that** the reproduction device, the light source (1, 2, 3) and the device for focusing and diffusing (4, 5, 10) occupy essentially the same area.

18. Device according to one of the preceding claims, **characterised in that** the image reproduction device (9) is a low-temperature polysilicon TFT display.

## Revendications

1. Dispositif pour générer une image, comprenant un dispositif de restitution d'image (9) contenant des valves de lumière, et une source de lumière pour le rétro-éclairage d'un dispositif de restitution d'image (9), comprenant une matrice de diodes électroluminescentes (1, 2, 3), un dispositif optique pour la concentration et la diffusion de la lumière générée par les diodes électroluminescentes étant disposé entre la source lumineuse et le dispositif de restitution d' image
- le dispositif pour la concentration et la diffusion comprenant un réflecteur (5) en forme de grille, qui forme à chaque fois pour un point de matrice un canal de lumière dont les parois (6) sont réfléchissantes,
**caractérisé en ce que** le dispositif de restitution d'image (9) présente sur un côté du dispositif une distance à la source de lumière (1, 2, 3) plus grande que sur l'autre côté, de telle sorte qu'une position inclinée du dispositif de restitution d'image est obtenue.

2. Dispositif selon la revendication 1, **caractérisé en ce qu'**un point de matrice est formé à chaque fois de plusieurs diodes électroluminescentes (1).

3. Dispositif selon la revendication 2, **caractérisé en ce que** les diodes électroluminescentes (1) à chaque fois d'un point de matrice émettent de la lumière de couleur différente.

4. Dispositif selon l'une quelconque des revendications 2 ou 3, **caractérisé en ce que** quatre diodes électroluminescentes
(1) forment un point de matrice.

5. Dispositif selon la revendication 4, **caractérisé en ce que** deux diodes électroluminescentes (1) éclairant en vert, une diode électroluminescente éclairant en bleu et une diode électroluminescente (1) éclairant en rouge sont prévues par points de matrice.

6. Dispositif selon la revendication 4, **caractérisé en ce que** deux diodes électroluminescentes éclairant en vert et deux diodes électroluminescentes éclairant en rouge sont prévues par points de matrice.

7. Dispositif selon l'une quelconque des revendications précédentes, **caractérisé en ce que** les points de matrice sont entourés chacun par un réflecteur (3, 24).

8. Dispositif selon l'une quelconque des revendications précédentes, **caractérisé en ce que** des filtres de couleur (14) des différents zones de passage spectraux sont attribués aux valves de lumière, les zones de passage des filtres de couleur (14) étant adaptées à la répartition de lumière spectrale des diodes électroluminescentes (1).

9. Dispositif selon la revendication 8, **caractérisé en ce qu'**au moins un filtre vert présente une zone de passage qui enregistre également des parties des zones spectrales de diodes électroluminescentes (1) éclairant en rouge et en vert.

10. Dispositif selon l'une quelconque des revendications précédentes, **caractérisé en ce que** la section de respectivement un canal de lumière s'étend en direction du dispositif de restitution d'image (9).

11. Dispositif selon l'une quelconque des revendications précédentes, **caractérisé en ce qu'**un autre réflecteur (8) en forme de cadre est prévu entre le réflecteur (5).

12. Dispositif selon l'une quelconque des revendications précédentes, **caractérisé en ce que** le dispositif pour la concentration et la diffusion comprend également un disque diffuseur (10) disposé entre le réflecteur (5) en forme de grille et le dispositif de restitution d'image (9), une distance étant prévue entre le réflecteur (5) en forme de grille et le disque diffuseur (10).

13. Dispositif selon la revendication 12, **caractérisé en ce que** le disque diffuseur (10) est un diffuseur structuré en surface.

14. Dispositif selon la revendication 13, **caractérisé en ce que** la surface est structurée de telle sorte que l'angle de diffusion est plus grand dans une direction que dans l'autre direction, de sorte qu'il se forme une dispersion elliptique.

15. Dispositif selon l'une quelconque des revendications précédentes, **caractérisé en ce que** le réflecteur (5) en forme de grille est injecté à base de matière synthétique.

16. Dispositif selon l'une quelconque des revendications précédentes, **caractérisé en ce qu'**entre le dispositif pour la concentration et la diffusion (4, 5, 10) et la source de lumière (1, 2, 3) est disposé un filtre de polarisation (27), qui laisse passer de la lumière d'une direction de polarisation prédéfinie et réfléchit la lumière d'autres directions de polarisation.

17. Dispositif selon l'une quelconque des revendications précédentes, **caractérisé en ce que** le dispositif de restitution, la source de lumière (1, 2, 3) et le dispositif pour la concentration et la diffusion (4, 5, 10) occupent sensiblement la même surface.

18. Dispositif selon l'une quelconque des revendications précédentes, **caractérisé en ce que** le dispositif de restitution d'image (9) est un écran TFT à polysilicium à basse température.
